# EUROPEAN PATENT SPECIFICATION

(11) **EP 2 360 715 B1**
(45) Date of publication and mention of the grant of the patent: **29.11.2017**
(21) Application number: 09825866.8
(22) Date of filing: 20.10.2009
(51) Int. Cl.: H01L 21/20, B21B 47/00, B23K 20/00, B23K 20/24, C22F 1/08, C22F 1/00

(54) **METHOD FOR MANUFACTURING METAL LAMINATED SUBSTRATE FOR SEMICONDUCTOR ELEMENT FORMATION AND METAL LAMINATED SUBSTRATE FOR SEMICONDUCTOR ELEMENT FORMATION**
VERFAHREN ZUR HERSTELLUNG EINES LAMINIERTEN METALLSUBSTRATS FÜR DIE HERSTELLUNG EINES HALBLEITERBAUELEMENTS UND LAMINIERTES METALLSUBSTRAT FÜR DIE HERSTELLUNG EINES HALBLEITERBAUELEMENTS
PROCEDE DE FABRICATION DE SUBSTRAT STRATIFIE METALLIQUE POUR LA FORMATION D'ELEMENT A SEMI-CONDUCTEUR ET SUBSTRAT STRATIFIE METALLIQUE POUR LA FORMATION D'ELEMENT A SEMI-CONDUCTEUR

(30) Priority: 12.11.2008 JP 2008290341
(43) Date of publication of application: 24.08.2011
(73) Proprietor: Toyo Kohan Co., Ltd., Tokyo 102-8447 (JP)
(72) Inventor: OKAYAMA, Hironao, Kudamatsu-shi Yamaguchi 744-8611 (JP); KANEKO, Akira, Kudamatsu-shi Yamaguchi 744-8611 (JP); NANBU, Kouji, Kudamatsu-shi Yamaguchi 744-8611 (JP)
(74) Representative: Vossius & Partner Patentanwälte Rechtsanwälte mbB
(86) International application number: PCT/JP2009/005472
(87) International publication number: WO 2010/055612

(56) References cited:
- EP-A1- 1 342 564
- EP-A2- 1 982 830
- JP-A- 9 153 456
- JP-A- 2000 357 660
- JP-A- 2008 266 686

## Description

### Technical Field

The present invention relates to a method of manufacturing a metal laminated substrate for forming an epitaxial growth film for forming a semiconductor element.

### Background Art

To obtain an excellent semiconductor element, it is necessary to form an epitaxial growth film having high orientation on a substrate.

For this end, conventionally, as a substrate for an epitaxial growth film, a monocrystalline wafer made of monocrystalline silicon (Si), monocrystalline GaAs, monocrystalline sapphire (Al₂O₃) or the like having an excellent crystal orientation has been used.

However, the monocrystalline wafer made of these materials is a cut plate having a size of approximately 300mmφ at most, and such a monocrystalline wafer cannot be formed by a continuous manufacturing method such as a reel-to-reel method. Further, also the strength of Si or the like is small and hence, the handling of the monocrystalline wafer made of Si or the like during the conveyance of the wafer is not easy whereby careful handling of the wafer is necessary.

Besides the above-mentioned monocrystalline wafer, as a substrate for forming an epitaxial growth film thereon, there has been known a metal substrate having the high biaxial crystal orientation which is formed such that cold rolling is applied to Ni, Cu, Ag or an alloy of these materials at a rolling reduction of not less than 90% thus imparting a uniform strain to the whole material and, thereafter, the material is recrystallized.

Although a substrate made of Ni or an Ni-W alloy whose crystals are oriented is used as a substrate for an oxide superconductor, the substrate is provided in the form of a crystal-oriented metal tape having a narrow width of 4 to 10mm, and there has been no substrate which is provided as a wide and long substrate with high crystal orientation.

Further, the above-mentioned Ni-W alloy has drawbacks that the Ni-W alloy is not a material which is used popularly in general so that a cost of the Ni-W alloy is high, the Ni-W alloy exhibits poor workability so that the manufacture of the substrate having a large width becomes difficult.

Further, as disclosed in patent documents 1, 2 and 3, as a material for forming a metal substrate which can overcome drawbacks in securing strength, there has been proposed a clad material which is formed by laminating a metal core layer and an Ni alloy layer by cold drawing or by a cold rolling method (patent documents 1, 2, 3).

Patent document 4 discloses a certain method for manufacturing a clad textured metal substrate for forming an epitaxial thin film thereon comprising the following steps:
(a) an orienting heat treatment step of cold-working a copper sheet at a working rate of 95% or more, and heat-treating the copper sheet obtained through the cold working in a non-oxidative atmosphere to make at least the surface part a {100}<001> cube texture having a deviating angle of crystal axes satisfying 6 degrees;
(b) a step of preparing a metal sheet; and
(c) a surface activated bonding step of dry-etching the surfaces to be bonded of the copper sheet obtained by the orienting heat treatment step and the metal sheet in a non-oxidation atmosphere to remove the oxide and adsorbate on the surfaces to be bonded, and bonding the copper sheet with the metal sheet without or through the application of pressure.

Patent document 5 relates to a process for producing a multilayered metal laminate, which comprises a step of setting a metal sheet on a reel for metal sheet unwinding, a step of setting a metal foil on a reel for metal foil unwinding, a step of unwinding the metal sheet from the metal sheet-unwinding reel and activating a surface of the metal sheet to form a first thin metal film on the metal sheet surface, a step of unwinding the metal foil from the metal foil-unwinding reel and activating a surface of the metal foil, and a step of press-bonding the activated surface of the first thin metal film to that of the metal foil. In another process described in this document, the last two steps are replaced by the following steps: a step of unwinding the metal foil from the metal foil-unwinding reel and activating a surface of the metal foil to form a second thin metal film on the metal sheet surface, and a step of press-bonding the activated surface of the first thin metal film to that of the second thin metal surface.
Patent document 1: JP-A-2006-286212
Patent document 2: JP-A-2007-200831
Patent document 3: JP-A-2001-110255
Patent document 4: EP 1 982 830 A2
Patent document 5: EP 1 342 564 A1

However, to laminate different kinds of metals with favorable adhesion by a cold rolling method, it is necessary to bond different kinds of metals to each other by diffusion bonding (diffusion heat treatment) as the pretreatment and, thereafter, to apply cold rolling to thebondedmetals . Although it has been known that working efficiency of 90% or more is necessary to impart the high crystal orientation to an Ni layer after diffusion heat treatment, when strong rolling is applied to the different kinds of metals in a bonded state, due to the difference in mechanical properties between both materials, the difference in elongation occurs between the materials and hence, a large warp occurs. Accordingly, it is difficult to manufacture a wide and long material.

Further, in the above-mentioned clad material, materials to be bonded constrain each other on a bonding interface so that rolling is performed while causing the non-uniform deformation of the clad material whereby the uniform strain cannot be induced in the thickness direction.

Further, the degree of roughness of the bonding interface is also increased so that the thickness of the Ni layer in which crystals are oriented also becomes non-uniform. Accordingly, in the heat treatment after bonding, the stable manufacture of the substrate having the uniform and high crystal orientation in the longitudinal direction becomes difficult.

### Disclosure of the Invention

### Problems that the Invention is to Solve

It is an object of the present invention to provide a method of manufacturing a metal laminated substrate for forming an epitaxial growth film for forming a semiconductor element having high biaxial crystal orientation on a surface of a metal substrate.

Further, it is another object of the present invention to provide a metal laminated substrate provided with a biaxial crystal orientation metal foil for forming an epitaxial growth film made of a semiconductor compound.

### Means for Solving the Problems

The problem is solved by claims 1-7.

### Advantageous effects of the Invention

According to the method of manufacturing a metal laminated substrate for forming a semiconductor element of the present invention, a metal plate and a Cu alloy foil rolled at a high rolling reduction for obtaining a metal crystal orientation surface which are manufactured with high thickness accuracy respectively in advance can be laminated to each other at a low rolling reduction with high accuracy and with a smooth interface.

The metal laminated substrate for forming semiconductor element which is manufactured by this manufacturing method can possess a high-accuracy biaxial crystal orientation on a surface of the substrate and hence, the semiconductor element can be formed on the substrate by an epitaxial growth with high accuracy.

### Best Mode for Carrying Out the Invention

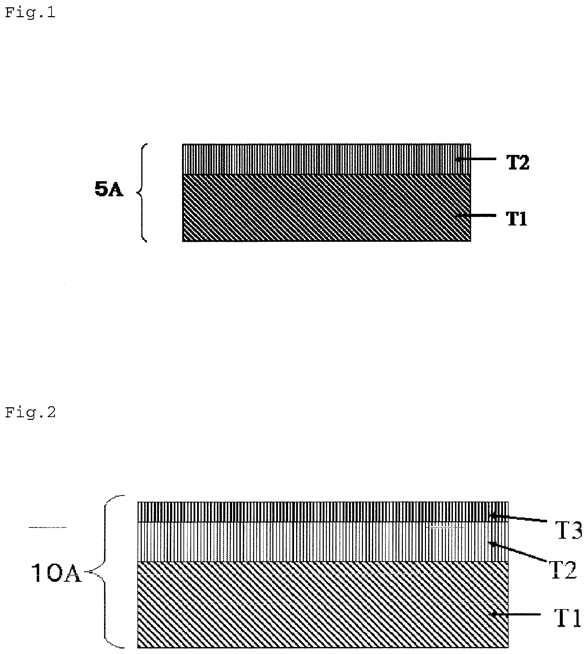

Fig. 1 is a schematic cross-sectional view showing the constitution of a metal laminated substrate 5A which is provided with a biaxially-crystal-oriented metal foil obtained by a manufacturing method of the present invention.

As shown in Fig. 1, the metal laminated substrate 5A obtained using the manufacturing method of the present invention is constituted of a metal plate T1 and a metal foil T2 which is laminated to the metal plate T1.

The metal plate T1 is selected depending on a purpose of use. When the metal plate T1 is a metal plate for a solar cell on which a polycrystalline silicon film is grown epitaxially, since it is necessary to impart proper strength to the metal plate T1, a thin plate made of Fe, Al, Ni, Cr, Ag, Cu, W, or an alloy of these materials (stainless steel, for example) is given as an example.

It is preferable to set a thickness of the metal plate T1 to not less than 0.05mm and not more than 0.2mm.

The reason the thickness of the metal plate T1 is set to not less than 0.05mm is to secure strength of the metal plate T1, and the reason the thickness of the metal plate T1 is set to not more than 0.2mm is to secure workability.

As the metal foil T2, a Cu foil or a Cu alloy foil (both the Cu foil and the Cu alloy foil also referred to as a Cu alloy foil in this specification) are given as examples. The metal foil T2 is required to possess the high crystal orientation in a state where a metal laminated substrate is formed.

Accordingly, heavy working is applied to the Cu alloy foil at a rolling reduction of not less than 90% before and after the Cu alloy foil is bonded to the metal plate T1 thus forming a rolled texture, and the crystal orientation is imparted to the Cu alloy foil by heat treatment which is performed after surface activation bonding.

This is because when the rolling reduction is less than 90%, there exists a possibility that Cu is not oriented in the heat treatment which is performed after working.

Such a high-reduction rolled Cu alloy foil having the rolled texture formed by heavy working at a rolling reduction of not less than 90% has been developed for imparting high bending property to the foil aiming at the use in a flexible printed circuit board, has become widespread, and can be easily obtained. For example, a high-reduction rolled Cu foil (product name: HA foil) made by Nikko Materials Ltd, a high-reduction rolled Cu foil (product name: HX foil) made by Hitachi Electric Wires., Ltd and the like are given as examples.

In the present invention, it is desirable to use the above-mentioned commercially available high-reduction rolled Cu alloy foils since these foils exhibit the excellent crystal orientation.

The metal foil has a thickness of not less than 7pom and not more than 50join, and it is desirable to use the metal foil having a thickness of not less than 12pm and not more than cm. The reason the thickness of the metal foil is set to not less than 7pom is to secure strength of the metal foil T2, and the reason the thickness of the metal foil is set to not more than 50pom is to secure workability of the metal foil T2.

Although any element may be used as an element to be added to the Cu alloy foil provided that the element allows the Cu alloy foil to easily elevate a (200) surface crystal rate to not less than 99% by heat treatment, trace amounts of Ag, Sn, Zn, Zr, O, N are added to the Cu alloy foil respectively, wherein a total amount of these elements is set to not more than 1%.

The reason the total amount of elements to be added is set to not more than 1% is that although the elements to be added and Cu form a solid solution, when the total amount of elements to be added exceeds 1%, there exists a possibility that impurities such as oxides other than solid solution are increased and the impurities influence the orientation.

Accordingly, it is preferable to set the total amount of elements to be added to not less than z and not more than 0.1%.

The metal plate and the Cu alloy foil formed by cold rolling at a rolling reduction of 90% or more which are explained heretofore are laminated to each other by a surface activation bonding method. The surface activation bonding means that surfaces of a substrate to be laminated and a metal foil to be laminated are activated by removing oxide, dirt and the like on the surfaces using a method such as sputter etching, the activated surfaces are brought into contact with each other and the laminate is subj ected to cold rolling. An intermediate layer may be provided to the surface of the substrate by sputtering.

As the above-mentioned surface activation bonding method, for example, a vacuum surface activation bonding device D1 shown in Fig. 4 can be used.

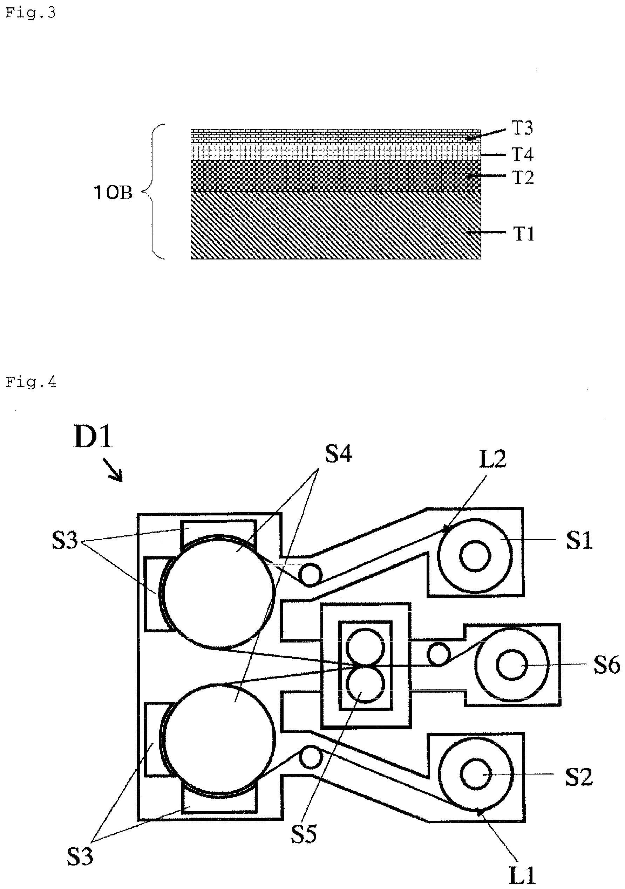

As shown in Fig. 4, a metal plate L1 and a metal foil L2 which becomes a Cu alloy foil are prepared as elongated coils having a width of 150mm to 600mm, and are mounted on recoiler portions S1, S2 of the surface activation bonding device D1.

The metal plate L1 and the metal foil L2 which are conveyed from the recoiler portions S1, S2 are continuously conveyed to a surface activation treatment step where activation treatment is applied to two surfaces to be bonded in advance and, thereafter, the metal plate L1 and the metal foil L2 are brought into pressure contact with each other by cold rolling.

In the surface activation treatment step, the surface activation treatment is performed by sputter etching treatment in an extremely-low-pressure inert gas atmosphere of 10 to 1×10⁻²Pa, wherein the metal plate L1 and the metal foil L2 having bonding surfaces are used as one electrodes A (S3) which are connected to a ground respectively, a glow discharge is generated by applying an AC current of 1 to 50MHz between the one electrodes A and the other electrodes B (S4) which are supported in an insulated manner, and an area of the electrode which is exposed in plasma generated by the glow discharge is not more than 1/3 of an area of the electrodes B.

As an inert gas, argon, neon, xenon, krypton or a mixture gas containing at least one kind selected from a group consisting of these gases is applicable.

In the sputter etching treatment, surfaces of the metal plate L1 and the metal foil L2 which are bonded to each other are subjected to sputtering by an inert gas so that surface adsorption layers and surface oxide films are removed whereby the bonding surfaces are activated. During this sputter etching treatment, the electrodes A(S3) take the form of cooling rolls thus preventing the elevation of temperatures of respective materials to be conveyed.

Thereafter, the metal plate L1 and the metal foil L2 are continuously conveyed to a pressure bonding roll step (S5) so that the activated surfaces are pressure-bonded to each other. When an O₂ gas or the like exists in the pressure bonding atmosphere, the activation processed surfaces are oxidized again during the conveyance and hence, the pressure bonding atmosphere influences the close contact between the metal plate L1 and the metal foil L2. Accordingly, it is desirable to perform the pressure bonding roll step (S5) under a high vacuum of 1×10⁻³Pa or less. Further, the lower a rolling reduction, the more excellent the accuracy in thickness becomes and hence, it is preferable to set the rolling reduction to not more than 10% for preventing the collapse of a state of the metal foil, and it is more preferable to set the rolling reduction to not more than 2%.

A laminated body formed by hermetically bonding the metal plate L1 and the metal foil L2 to each other through the above-mentioned pressure bonding step is conveyed to a winding step (S6), and is wound in the step.

Next, after laminating the metal plate L1 and the metal foil L2 to each other by the surface activation bonding method, heat treatment is applied to the laminated body so as to highly orient crystals of the high-reduction rolled Cu alloy foil.

To allow the high-reduction rolled Cu alloy foil to finish the recrystallization completely, it is necessary to set a heat treatment temperature to a temperature of not lower than 150°C.

A soaking time may preferably be set to 3 to 5 minutes, and when the heat treatment is performed using a continuous annealing furnace, a soaking time may be set to approximately 10 seconds.

When the heat treatment temperature is set to an excessively high temperature, secondary recrystallization is liable to occur in the rolled Cu alloy foil so that the crystal orientation is deteriorated. Accordingly, the heat treatment is performed with the heat treatment temperature of not lower than 150°C and not higher than 1000°C.

After performing the heat treatment in this manner, the metal laminated substrate having high biaxial crystal orientation can be manufactured.

As shown in Fig. 2, on this metal laminated substrate, various kinds of epitaxial growth films T3 made of a semiconductor compound such as a solar-cell-use polycrystalline silicon (Si) film, a light-emitting-diode-use gallium nitride (GaN) film, a TiO₂ film by which a photocatalytic effect and a photoelectric effect can be expected may be grown thus forming a semiconductor element.

Here, in a step of growing the epitaxial growth film, there may be a case where a Cu alloy foil reacts with a film forming gas depending on a film forming condition so that an epitaxial growth film having excellent adhesiveness cannot be formed on the Cu alloy foil or the epitaxial growth is not generated.

Such a drawback can be overcome by, as shown in Fig. 3, forming a protective film T4 on the Cu alloy foil T2 of the metal laminated substrate.

The protective film T4 may be made of metal such as Ni, Mo which exhibits excellent high-temperature corrosion resistance, an oxide made of an insulation material such as MgO or ZnO, or a nitride such as AIN or InGaN.

A thickness of the protective film T4 is preferably set to not less than 0.5µm to prevent the dispersion of Cu which is a background material. Further, to form a film used for other purposes on the protective film by an epitaxial growth, it is also necessary to form the protective film by an epitaxial growth and hence, it is preferable to set a thickness of the protective film to not more than 10µm. This is because when the thickness of the protective film becomes more than 10µm, the crystal orientation of the protective film is lowered.

For example, in manufacturing a semiconductor element where a GaN film is formed as an epitaxial growth film T3 so as to use the semiconductor element as a blue light emitting diode, an InGaN layer or a ZnO layer is formed on the Cu alloy foil T2 as the protective film T4, and a GaN film can be formed on the protective film T4.

As a means for forming the epitaxial growth film T3, a known means such as an electrolytic plating method, a non-electrolytic plating method, a vacuum vapor deposition method or a sputtering film forming method can be used.

It is necessary to form the epitaxial growth film T3 by an epitaxial growth and it is desirable to set a film thickness of the epitaxial growth film T3 to not less than 1nm and not more than 10µm.

This is because when the film thickness of the epitaxial growth film T3 is less than 1nm, the epitaxial growth film T3 cannot impart a function necessary for a semiconductor element to the semiconductor element, while when the film thickness exceeds 10µm, a film thickness of the epitaxial growth film T3 becomes excessively large.

Next, the explanation is made with respect to the surface roughness of a metal foil (Cu alloy foil) whose crystals are oriented on the metal laminated substrate.

The lower the surface roughness (average surface roughness) Ra of the metal foil, the more the crystal orientation is improved. Accordingly, in a case of a metal foil whose surface roughness Ra is 100nm or more, after surface activation bonding, the treatment which adjusts the surface roughness Ra to not more than 40nm is performed.

As a method of lowering the surface roughness, the rolling reduction using pressure rolls, buffing, electrolytic polishing, electrolytic abrasive grain polishing and the like are considered. However, any method can be used. Although it is desirable to set the surface roughness to a mirror surface level, by taking a currently available technique and an economic aspect into consideration, it is desirable to set the surface roughness Ra to not less than 1nm and not more than 10nm.

By performing the above-mentioned surface roughness adjustment, it is possible to acquire the more excellent metal laminated substrate for an epitaxial growth film and hence, a high-performance functional film can be formed on the substrate.

By manufacturing the metal laminated substrate for an epitaxial growth film by surface activation bonding as described above, the Cu metal foil can be laminated to the metal substrate with an interface formed between the Cu metal foil and the metal substrate made smooth while maintaining a state where the metal foil is cold-rolledat a high rolling reduction. This is because, in biaxially orienting crystals of the metal foil by heating after such cold rolling, when a state where the Cu metal foil is cold-rolled at a high rolling reduction is not maintained, required biaxial crystal orientation is not generated. Further, when the interface is not smooth, there exists a possibility that the biaxial crystal orientation collapses.

Further, by adopting the surface active bonding method, the metal foil can be laminated to the metal substrate with favorable adhesiveness. It may be possible to laminate the metal foil on the metal substrate with favorable adhesiveness using an adhesive agent. In this case, however, there exists a possibility that the adhesive agent is deteriorated or modified due to heating after lamination leading to the collapse of the biaxial crystal orientation.

### Example 1

Hereinafter, an embodiment of the present invention is exemplified, wherein properties of the manufactured metal laminated substrate are explained. A high-reduction rolled Cu foil (metal foil) having a width of 200mm and a thickness of 18µm and an SUS316L plate (metal plate) having a thickness of 100µm are bonded to each other by a room-temperature surface activation bonding method and, thereafter, the high-reduction rolled Cu foil and the SUS316L plate are subjected to heat treatment at a temperature of 200°C to 1000°C for five minutes thus acquiring the metal laminated substrate.

Table 1 shows a rate at which a Cu (200) surface is made parallel to a Cu foil surface, that is, a crystal orientation rate (a diffraction peak strength rate of a (200) surface at a θ/2θ diffraction peak measured by X-ray diffraction: I(₂₀₀)/∑I₍ₕₖ₁₎×100(%)), and a Δφ° (φ scan peak (an average value of half value widths of 4 peaks at α=35°) obtained by an Ni (111) pole figure in accordance with X-ray diffraction) which indicates that the (200) surface is parallel to the longitudinal direction <001>, that is, a biaxial crystal orientation index.

As comparison examples, peak strength rates when the heat treatment is performed at a temperature of 130°C and 1050°C are also shown. Also as a comparison example, shown is a peak strength rate when a high-reduction rolled Ni foil having a thickness of 30µm is bonded instead of the Cu foil by the above-mentioned room-temperature activation bonding method and, thereafter, heat treatment is applied to the high-reduction rolled Ni foil at a temperature of 1000°C for 1 hour.

As can be understood from Table 1, in the high-reduction rolled Cu foil, the crystal orientation rate is 93% when the heat treatment is performed at a heat treatment temperature of 130°C for 5 minutes and hence, the crystal orientation rate is not yet sufficient. However, when the heat treatment temperature falls within a range from 200°C to 1000°C, the (200) surface crystal orientation rate becomes 99% or more when such heat treatment temperature is held for 5 minutes.

When the heat treatment temperature exceeds 1000°C, the uniaxial orientation of the (200) surface collapses due to the secondary recrystallization so that the strength rate is lowered to 70%.

Withrespect to the Ni foil which is shown as the comparison example, the recrystallization temperature is around 700°C and the strength rate is 98% even with the heat treatment at a temperature of 1000°C which is considered as the optimum heat treatment temperature whereby the strength rate does not reach 99% and Δφ is also 15.4°.

Here, the measured value described above is an average of values measured at three points consisting of areas in the vicinity of both ends of the plate and the center of the plate having a size of 200mm in the widthwise direction, and no difference is substantially recognized with respect to the value among the embodiments.

**[Table 1]**

| Example | Sample | Heat treatment temperature (°C) | Crystal orientation rate (%) | Δφ (°) |
|---|---|---|---|---|
| Comparison example 1-1 | Cu/SUS316L | 130 | 93.0 | Not measured |
| Example 1-1 | | 200 | 99.8 | 6.0 |
| Example 1-2 | | 300 | 99.9 | 6.0 |
| Example 1-3 | | 500 | 99.9 | 5.8 |
| Example 1-4 | | 700 | 100.0 | 5.8 |
| Example 1-5 | | 800 | 100.0 | 5.6 |
| Example 1-6 | | 900 | 100.0 | 5.4 |
| Example 1-7 | | 1000 | 99.0 | 5.3 |
| Comparison example 1-2 | | 1050 | 70.5 | Not measured |
| Comparison example 1-3 | Ni/SUS316L | 1000 | 98.4 | 15.4 |

As shown in Table 1, the metal laminated substrates which are manufactured by the manufacturing method of the present invention can be manufactured as an elongated coil having a large width whi le maintaining the uniform crys tal orientation and hence, the metal laminated substrates can be used as substrates for various epitaxial growth films.

### Industrial applicability

According to the present invention, it is possible to provide a metal laminated substrate constituted of an elongated coil which can be continuously formed by a reel-to-reel method, and a crystal-oriented polycrystalline silicon film for a solar cell or a semiconductor compound such as a GaN element for a light emitting diode are formed on the metal laminated substrate as an epitaxial growth film. Accordingly, the metal laminated substrate can be used as a new material for an epitaxial growth film in new fields where the utilization of the metal laminated substrate has not been studied and hence, the present invention is industrially extremely useful.

### Brief explanation of drawing

[Fig. 1] A schematic cross-sectional view showing the constitution of a metal laminated substrate 5A obtained by carrying out a manufacturing method of the present invention.
[Fig. 2] A schematic cross-sectional view showing the constitution in a state 10A where an epitaxial growth film T3 is formed on the metal laminated substrate of the present invention.
[Fig. 3] A schematic cross-sectional view showing the constitution in a laminated state 10B where a Cu alloy foil T2 is laminated to a metal plate T1 by surface active bonding and, after heat treatment, a protection layer T4 is provided and, thereafter, a target epitaxial growth film T3 is formed.
[Fig. 4] A schematic view of a surface activation bonding device D1 used in the present invention.

### Explanation of symbols

T1: metal plate
T2: Cu foil or Cu alloy foil
T3: epitaxial growth film
T4: protective layer
5A: metal laminated substrate
10A: cross-sectional view showing a state where epitaxial growth film T3 is formed on metal laminated substrate
10B: cross-sectional view showing a state where protective later T4 is formed on metal laminated substrate and, thereafter, epitaxial growth film T3 is formed

## Claims

1. A method of manufacturing a metal laminated substrate for forming a semiconductor element comprising the steps of:
activating at least one surface of a metal plate;
activating at least one surface of a metal foil made of Cu or a Cu alloy, having a thickness of not less than 7µm and not more than 50µm, which is cold-rolled at a rolling reduction of 90% or more:
laminating the metal plate and the metal foil such that an activated surface of the metal plate and an activated surface of the metal foil face each other in an opposed manner and applying cold rolling to the metal plate and the metal foil which arc laminated to each other; and
biaxially orienting crystals of the metal foil by heat treatment after the lamination.

2. The method of manufacturing a metal laminated substrate for forming a semiconductor element according two claim 1. wherein the activation treatment is performed by sputter etching.

3. The method of manufacturing a metal laminated substrate for forming a semiconductor element according to claim 1 or claim 2, wherein the cold rolling is performed at a rolling reduction of not more than 10% at lamination.

4. The method of manufacturing a metal laminated substrate for forming a semiconductor element according to any one of claim 1 to 3. wherein the foil made of the Cu alloy contains not less than 0.01% and not more than 1% in total of Ag, Sn, Zn, Zr, O and N.

5. The method of manufacturing a metal laminated substrate for forming a semiconductor element according to any one of claims 1 to 4, wherein the heat treatment after the lamination is performed at a temperature of not lower than 150°C and not higher than 1000°C.

6. The method of manufacturing a metal laminated substrate for forming a semiconductor element according to any one of claims 1 to 5, wherein before the heat treatment, a polish treatment is applied to the metal laminated substrate such that the surface roughness of a metal-foil-side surface of the metal laminated substrate becomes not less than 1nm and not more than 40nm by Ra.

7. The method of manufacturing a metal laminated substrate for forming a semiconductor element according to any one of claims 1 to 6, wherein a protective film having a thickness of not less than 1nm and not more than 10µm is further formes on the metal laminated substrate which is manufactured by the method of manufacturing a metal laminated substrate.

## Patentansprüche

1. Ein Verfahren zur Herstellung eines laminierten Metallsubstrats für die Bildung eines Halbleiterbauelements, umfassend die Schritte:
Aktivieren mindestens einer Oberfläche einer Metallplatte;
Aktivieren mindestens einer Oberfläche einer Metallfolie, die aus Cu oder einer Cu-Legierung hergestellt wurde, eine Dicke von nicht weniger als 7 µm und nicht mehr als 50 µm aufweist und bei einer Walzreduktion von 90 % oder mehr kaltgewalzt ist;
Laminieren der Metallplatte und der Metallfolie, sodass eine aktivierte Oberfläche der Metallplatte und eine aktivierte Oberfläche der Metallfolie einander gegenüberliegen, und Anwenden von Kaltwalzen auf die Metallplatte und die Metallfolie, die miteinander laminiert sind; und
biaxiales Orientieren von Kristallen der Metallfolie durch Wärmebehandlung nach der Laminierung.

2. Das Verfahren zur Herstellung eines laminierten Metallsubstrats für die Bildung eines Halbleiterbauelements gemäß Anspruch 1, wobei die Aktivierungsbehandlung mittels Sputterätzen durchgeführt wird.

3. Das Verfahren zur Herstellung eines laminierten Metallsubstrats für die Bildung eines Halbleiterbauelements gemäß Anspruch 1 oder Anspruch 2, wobei das Kaltwalzen bei einer Walzreduktion von nicht mehr als 10 % beim Laminieren durchgeführt wird.

4. Das Verfahren zur Herstellung eines laminierten Metallsubstrats für die Bildung eines Halbleiterbauelements gemäß einem der Ansprüche 1 bis 3, wobei die Folie, die aus der Cu-Legierung hergestellt wurde, insgesamt nicht weniger als 0,01% und nicht mehr als 1% an Ag, Sn, Zn, Zr, O und N enthält.

5. Das Verfahren zur Herstellung eines laminierten Metallsubstrats für die Bildung eines Halbleiterbauelements gemäß einem der Ansprüche 1 bis 4, wobei die Wärmebehandlung nach dem Laminieren bei einer Temperatur von nicht weniger als 150°C und nicht höher als 1000°C durchgeführt wird.

6. Das Verfahren zur Herstellung eines laminierten Metallsubstrats für die Bildung eines Halbleiterbauelements gemäß einem der Ansprüche 1 bis 5, wobei das laminierte Metallsubstrat vor der Wärmebehandlung einer Polierbehandlung unterzogen wird, sodass der Ra-Oberflächenrauheitswert einer Oberflächenseite des laminierten Metallsubstrats mit der Metallfolie nicht weniger als 1 nm und nicht mehr als 40 nm beträgt.

7. Das Verfahren zur Herstellung eines laminierten Metallsubstrats für die Bildung eines Halbleiterbauelements gemäß einem der Ansprüche 1 bis 6, wobei ferner ein Schutzfilm mit einer Dicke von nicht weniger als 1 nm und nicht mehr als 10 µm auf dem laminierten Metallsubstrat gebildet wird, welches durch das Verfahren zur Herstellung eines laminierten Metallsubstrats hergestellt ist.

## Revendications

1. Procédé de fabrication d'un substrat métallique stratifié pour former un élément semi-conducteur comprenant les étapes de :
activer au moins une surface d'une plaque métallique ;
activer au moins une surface d'une feuille métallique constituée de Cu ou d'un alliage de Cu, ayant une épaisseur qui n'est pas inférieure à 7 µm et pas supérieure à 50 µm, qui est laminée à froid avec une réduction de laminage de 90 % ou plus ;
laminer la plaque métallique et la feuille métallique de sorte qu'une surface activée de la plaque métallique et une surface activée de la feuille métallique se fassent mutuellement face d'une manière opposée et appliquer un laminage à froid à la plaque métallique et à la feuille métallique qui sont lamifiées l'une sur l'autre ; et
orienter de manière biaxiale des cristaux de la feuille métallique par un traitement thermique après la lamification.

2. Procédé de fabrication d'un substrat métallique stratifié pour former un élément semi-conducteur selon la revendication 1, dans lequel le traitement d'activation est effectué par gravure par pulvérisation.

3. Procédé de fabrication d'un substrat métallique stratifié pour former un élément semi-conducteur selon la revendication 1 ou la revendication 2, dans lequel le laminage à froid est effectué avec une réduction de laminage qui n'est pas supérieure à 10 % lors de la lamification.

4. Procédé de fabrication d'un substrat métallique stratifié pour former un élément semi-conducteur selon l'une quelconque des revendications 1 à 3, dans lequel la feuille constituée de l'alliage de Cu ne contient pas moins de 0,01 % et pas plus de 1 % au total d'Ag, de Sn, de Zn, de Zr, d'O et de N.

5. Procédé de fabrication d'un substrat métallique stratifié pour former un élément semi-conducteur selon l'une quelconque des revendications 1 à 4, dans lequel le traitement thermique après la lamification est effectué à une température qui n'est pas inférieure à 150 °C et pas supérieure à 1000 °C.

6. Procédé de fabrication d'un substrat métallique stratifié pour former un élément semi-conducteur selon l'une quelconque des revendications 1 à 5, dans lequel, avant le traitement thermique, un traitement de polissage est appliqué au substrat métallique stratifié de sorte que la rugosité de surface d'une surface côté feuille métallique du substrat métallique stratifié ne devienne pas inférieure à 1 nm et pas supérieure à 40 nm par Ra.

7. Procédé de fabrication d'un substrat métallique stratifié pour former un élément semi-conducteur selon l'une quelconque des revendications 1 à 6, dans lequel un film de protection ayant une épaisseur qui n'est pas inférieure à 1 nm et pas supérieure à 10 µm est en outre formé sur le substrat métallique stratifié qui est fabriqué par le procédé de fabrication d'un substrat métallique stratifié.
